# EUROPEAN PATENT SPECIFICATION

(11) **EP 2 739 907 B1**
(45) Date of publication and mention of the grant of the patent: **30.11.2016**
(21) Application number: 12769721.7
(22) Date of filing: 06.08.2012
(51) Int. Cl.: F23N 5/10, H01L 35/34

(54) **MANUFACTURING METHOD FOR A COOKING RANGE THERMOCOUPLE AND THERMOCOUPLE OBTAINED THEREWITH**
HERSTELLUNGSVERFAHREN EINES THERMOELEMENTS FÜR EINEN KOCHBEREICH UND AUF DIESE WEISE HERGESTELLTES THERMOELEMENT
PROCÉDÉ DE FABRICATION POUR UN THERMOCOUPLE DE FOURNEAU DE CUISINE, ET THERMOCOUPLE AINSI OBTENU

(30) Priority: 05.08.2011 IT TO20110736
(43) Date of publication of application: 11.06.2014
(73) Proprietor: Illinois Tool Works Inc., Glenview, IL 60025 (US)
(72) Inventor: PIANEZZE, Daniele, 21012 Cassano Magnago (IT)
(74) Representative: Plebani, Rinaldo
(86) International application number: PCT/IB2012/054013
(87) International publication number: WO 2013/021341

(56) References cited:
- EP-A1- 1 669 673
- JP-A- 1 139 917
- US-A- 2 114 446
- US-A- 2 207 771
- US-A- 2 678 092
- US-A- 2 922 083
- US-A- 2 936 122

## Description

### TECHNICAL FIELD

The present invention relates to a manufacturing method for a thermocouple intended for a cooking range as well as to the thermocouple obtained therewith. Thermocouples of this type are normally installed on each burner of a cooking range and control the safety solenoid valve of the gas tap coupled to the burner.

### BACKGROUND ART

The thermocouples of the above type have an electrically conducting body made at numerical control by chip removal from an extruded tube or bar of a brass alloy, which body carries the so-called "hot junction" of the thermocouple at a first end, consisting of a tip made of a first metal alloy and intended to remain in use immersed in the flame generated by the burner, and of a conducting element made of a second metal alloy, welded to the tip at an end thereof and for the rest electrically insulated therefrom; a polarity wire is connected to such a second conducting element while a ground wire is connected to the body, which is mechanically and electrically connected to the tip. An electro-motive force is thus generated at the terminals of the two wires, which keeps an electromagnet of the gas tap energized, thus allowing the gas supply to continue. If the flame goes off, the electro-motive force stops and the electromagnet interrupts the gas supply.

Therefore, the conducting body of the thermocouple has a dual function: on the one hand, it serves for allowing the thermocouple to be mounted to the burner, and to this end it is usually provided with gripping means defined by a hexagonal-section portion of the body, and with a thread adapted to receive a fastening nut in use; on the other hand, the conducting body belongs to the chain of resistors arranged in series between the hot junction and the "cold" junction of the thermocouple, represented by the end of the two wires. The lower the electrical resistance, the faster the thermocouple "response", i.e. the time elapsing from the onset of the flame after which the electro-motive force generated is capable of keeping the electromagnet energized.

The thermocouples currently available are relatively expensive, and complex and slow to be machined, because the body must be obtained by chip removal. Moreover, the body has a relatively large mass, which is required by its carrying functions, thus resulting in relatively long response times of the thermocouple, which is annoying for the user as, until the electro-motive force generated by the thermocouple is not sufficient for keeping the gas tap open, he/she must continue to press on the switch button. US2114446 teaches a thermocouple having a body defined by a copper tube length, difficult to be used in current cooking ranges and which does not overcome the drawbacks of the prior art.

### DISCLOSURE OF INVENTION

It is an object of the present invention to overcome such drawbacks by providing a method for manufacturing a thermocouple having very short response times, being easy and quick to carry out and with considerable saving over the known methods. Moreover, it is an object of the invention to provide a thermocouple made by means of such method, which has short response times and low production costs.

The present invention thus relates to a method for manufacturing a thermocouple of a burner of a cooking range of a household appliance as defined in claim 1, as well as to a thermocouple for a burner of a cooking range as defined in claim 7.

In particular, the method of the invention provides for manufacturing the thermocouple body by first forming a tube length delimited by a side wall being less than 1 mm thick, from a flat metal sheet by plastically deforming and shearing the same metal sheet; and thereafter or at the same time, again by plastically deforming said side wall of the tube length, forming at least one annular axial abutment and, at a predetermined axial distance from the axial abutment, at least one annular groove obtained by plastically deforming the side wall towards the interior of the tube length.

The hot junction of the thermocouple is then formed and it is axially inserted into the body so as to make the tip exit from a first end of the body, away from the annular abutment, and the tip is welded to the side wall of the body.

A thermocouple is thus obtained, of the type comprising an electrically conducting body fixable in use to a burner of a cooking range; a hot junction consisting of a tip made of a first conducting metal alloy, integrally carried by the body and by a conducting element made of a second metal alloy, accommodated within the tip, welded to a first end thereof; an insulating element interposed between the tip and the conducting element made of the second metal alloy; a polarity wire connected to the conducting element made of the second metal alloy; and a ground wire directly connected to the conducting body; wherein the conducting body consists of a tube length made of a metal sheet which has been plastically deformed and sheared, and which is delimited by a side wall being less than 1 mm thick on which at least one annular axial abutment has been obtained and, at a predetermined axial distance from the axial abutment, at least one annular groove has been obtained by plastically deforming the side wall towards the interior of the tube length. The thermocouple can further comprise an elastically deformable clip for fastening the body to the burner of the cooking range, adapted to be snappingly coupled to the at least one annular groove.

Thereby, the construction of the body is greatly simplified and made faster and less expensive; moreover, a consistent reduction in the body mass is obtained, with consequent large reduction in the response times of the thermocouple. Finally, the body is fastened to the burner without using nuts and threads, but in a quick manner, by sandwiching the mounting seat of the body on the burner between the annular axial abutment obtained on the body and the fastening clip, snappingly mounted in the at least one groove of the body. By obtaining one or more of said annular grooves, the same body may be used for thermocouples intended to be mounted to different burner models, having seats of a different thickness for the thermocouple.

### BRIEF DESCRIPTION OF THE DRAWINGS

Further features and advantages of the present invention will become apparent from the following description of preferred embodiments thereof, made by way of a non-limiting example and with reference to the accompanying drawings, in which:
- figure 1 shows a longitudinal cutaway view of a thermocouple made according to the invention;
- figure 2 shows an enlarged scale view of a detail of the thermocouple in figure 1; and
- figure 3 shows a further enlarged view of a component of the thermocouple in figure 1 at the end of one of the machining steps of the method according to the invention.

### BEST MODE FOR CARRYING OUT THE INVENTION

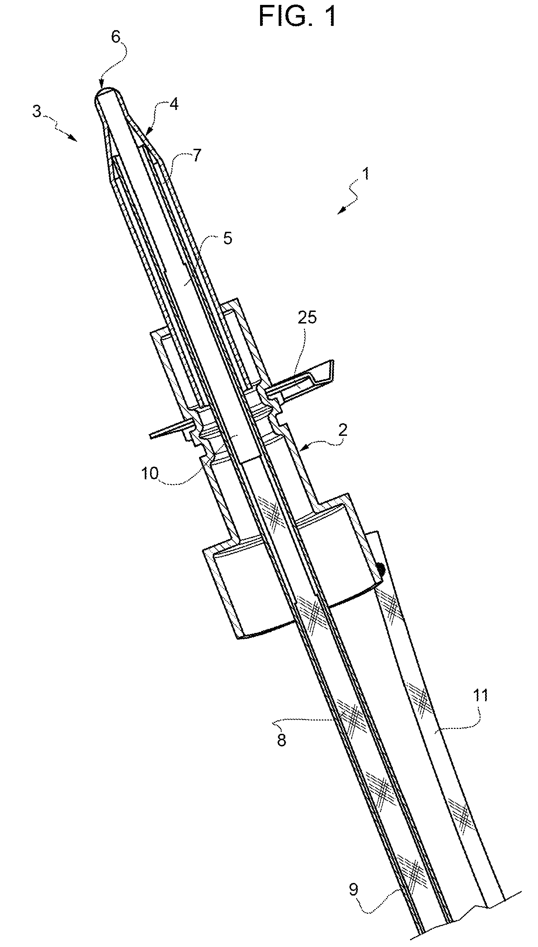

With reference to figures 1 to 3, reference numeral 1 indicates a thermocouple intended to equip, in a known manner, a burner of a cooking range of a household appliance (known and not shown for simplicity).

Thermocouple 1 comprises an electrically conducting body 2 fixable in use to the burner of a cooking range; and a hot junction 3 consisting of a tip 4 made of a first conducting metal alloy, typically a NiCr9010 alloy (90% by weight nickel and 10% by weight chromium), and of a conducting element 5 made of a second metal alloy, typically constantan (55-60% by weight copper and 40-45% by weight nickel); tip 4 is integrally carried by body 2 and the conducting element 5 is accommodated within tip 4, welded to a nose-shaped end 6 thereof.

Thermocouple 1 further comprises an insulating element 7 interposed between tip 4 and the conducting element 5 made of the second metal alloy; a polarity wire 8 provided with an insulating sheath 9 and connected to an end 10 of the conducting element 5 opposite to the end 6 of the tip to which element 5 is mechanically and electrically coupled by welding; and a ground wire 11 directly connected to the conducting body 2.

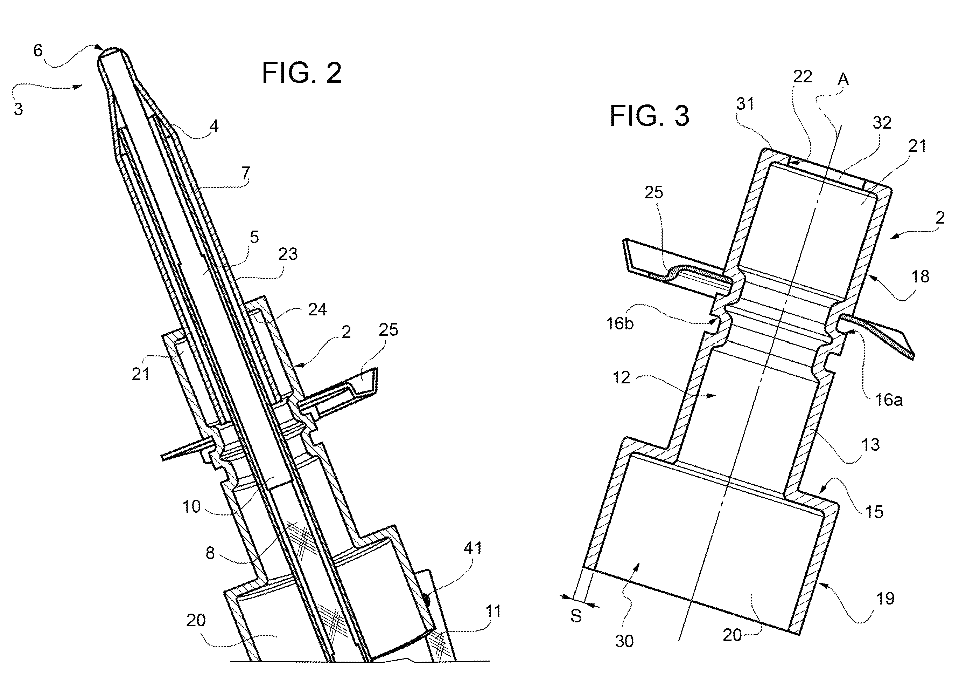

According to the main feature of the invention, and with particular reference to figure 3, the conducting body 2 consists of a tube length 12 made of a metal sheet, typically a brass sheet, which has been plastically deformed and sheared and which is delimited by a side wall 13.

Body 2 has a symmetry axis A and generally has an axial-symmetric shape and, according to a feature of the invention, the side wall 13 has a thickness S measured in the radial direction with respect to axis A always less than 1 mm and preferably in the range between 0.5 and 0.8 mm.

According to the invention, at least one annular axial shoulder or abutment 15 and at least one annular groove 16 have been obtained on the side wall 13 by plastic deformation; annular groove 16 has been obtained at a predetermined axial distance from the axial abutment 15, by plastically deforming the side wall 13 towards the interior of the tube length 12.

In the practice, the side wall 13 of the tube length 12 consists of an axial sequence of revolution surface segments of different outer diameter, in the example shown in figures 1-3, of two cylindrical segments 18 and 19; two of these surface segments, immediately adjacent to each other, in particular segments 18, of smaller diameter, and 19, of larger diameter, due to the difference in diameter define the annular axial shoulder or abutment 15.

With its end away from shoulder 15, segment 19 defines a first end 20 of body 2 while, likewise, with its end away from shoulder 15, segment 18 defines a second end 21 of body 2 provided with a through seat 22 for tip 4, a cylindrical side wall 23 of which is welded by a continuous or discontinuous bead 24 to the side wall 13.

Thermocouple 1 according to one embodiment of the invention further comprises an elastically deformable clip 25 for fastening body 2 to a burner of the cooking range; clip 25 is adapted to snappingly couple to the at least one annular groove 16 provided on body 2 for defining, together with shoulder or abutment 15, a pair of axial locking elements adapted in use to sandwich the seat on the burner for thermocouple 1; in the example shown, body 2 is provided with two grooves 16a and 16b arranged at different axial distances from shoulder 15, so as to adapt thermocouple 1 to different burner models, and clip 25 is shaped like a cup spring.

According to the method of the invention, the following steps are combined for manufacturing the above thermocouple 1.

First, the tube length 12 is formed ensuring that it is delimited by a side wall 13 being always less than 1 mm thick and preferably in the range between 0.5 and 0.8 mm, starting from a flat metal sheet; the tube length 12 is formed by plastically deforming and shearing such metal sheet forming, at the same time at least the annular axial shoulder or abutment 15 on the side wall 13 of the tube length 12 and, at a predetermined axial distance from the axial abutment 15, the at least one annular groove 16 which, according to the invention, is obtained by plastically deforming the side wall 13 towards the interior of the tube length 12; thereby, once shoulder 15 and grooves 16a, 16b have been made, body 2 is finished; at this step, it is essential for thickness S of the side wall 13 to be less than 1 mm, otherwise body 2 could not be shaped as desired. Moreover, a thickness S in the range between 0.5 and 0.8 mm imparts sufficient sturdiness to body 2 at the same time.

Thereafter (or at the same time), the hot junction 3 is formed separately and it is axially inserted into body 2 so as to make tip 4 exit from end 21 of body 2; such an end 21 is selected so as to be the farthest from the annular abutment 15 between the two ends 20 and 21. Finally, tip 4 is directly welded to the side wall 13 of body 2.

According to the invention, the tube length 12 is obtained by first drawing said metal sheet when it is still flat, so as to form a cup-shaped dead bush 30 (figure 3) delimited by the side wall 13 and by a flat bottom wall 31; and then shearing a through hole 32 through the flat bottom wall 31, so as to form the through seat 22 therewith for accommodating tip 4; during the drawing step, the axial abutment 15 is made on the side wall 13 since the side wall 13 of the tube length 12 is formed as an axial sequence of revolution surface segments of different outer diameter, actually forming the two cylindrical segments 18 and 19.

Therefore, according to this embodiment, the side wall 13 is a continuous side wall formed as a single piece.

According to the invention, therefore, the conducting body 2 of thermocouple 1 defined by the tube length 12 is obtained so that it defines the cup-shaped dead bush 30 delimited by the side wall 13 with the axial abutment 15 and by the flat bottom wall 31 provided with the through hole 32 which defines and forms the through seat 22 for accommodating tip 4.

According to the embodiment shown, the hot junction 3 is made (figure 2) so that, upon the insertion into the conducting body 2 defined by the tube length 2, the end 10 of the conducting element 5 made of the second metal alloy protrudes into the tube length 12 from the side opposite to tip 4 and the insulating element 7 which is made as a cylindrical insulating sheath made of glass fiber, is then inserted between the conducting element 5 and tip 4.

Thermocouple 1 is completed by fastening the polarity wire 8 to the end 10 of the conducting element 5 (this operation is preferably carried out before inserting the hot junction 3 into body 2) which protrudes into the tube length 12, and by fastening the ground wire 11 to body 2; according to the invention, conductor 11 is directly welded outside the conducting body 2, at the end 20 of body 2 which is opposite to the end 21 provided with tip 4. In particular, wire 11 is directly welded on the side wall 13 of the tube length 12, securing it by a welding spot 41.

## Claims

1. A method of manufacturing a thermocouple (1) of the type comprising an electrically conducting body (2) fixable in use to a burner of a cooking range and a hot junction (3) consisting of a tip made of a first conducting metal alloy, integrally carried by the body, and of a conducting element made of a second metal alloy, accommodated within the tip, welded to one end thereof, comprising the steps of:
- forming a tube length (12) delimited by a side wall (13) being less than 1 mm thick starting from a flat metal sheet by plastically deforming and shearing said metal sheet;
- again by plastically deforming said side wall (13), forming at least one annular axial abutment (15) and, at a predetermined axial distance from the axial abutment, at least one annular groove (16) obtained by plastically deforming the side wall (13) towards the interior of the tube length so as to make said body (2);
- forming said hot junction (3) and then axially inserting the same into the body so as to make the tip (4) exit from a first end of the body (2); and
- welding the tip (4) to the side wall (13) of the body; **characterized in that** said tube length (12) is obtained by first working said metal sheet so as to form a cup-shaped dead bush (30) delimited by said side wall (13) and by a flat bottom wall (31); and then shearing a through hole (32) through the flat bottom wall (31), so as to obtain a through seat (22) for accommodating the tip (4); said axial abutment (15) being made on the side wall (13) during said step of working the metal sheet.

2. A method according to claim 1, **characterized in that** said tube length (12) is obtained by drawing said metal sheet when it is still flat, so as to form said dead bush (30).

3. A method according to claim 1, **characterized in that** said tube length (12) is obtained by shearing and bending said flat metal sheet, the continuity of said side wall (13) being interrupted by a longitudinal junction defined by opposite longitudinal edges of the sheared and bent sheet.

4. A method according to one of the preceding claims, **characterized in that** said side wall (13) of the tube length is formed as an axial sequence of revolution surface segments (18, 19) of different outer diameter.

5. A method according to one of the preceding claims, **characterized in that** the hot junction (3) is made so that, upon the insertion into the conducting body (2) defined by said tube length, one end (10) of the conducting element (5) made of the second metal alloy protrudes into the tube length from the side opposite to the tip (4); an insulating sheath (7) made of glass fiber being then inserted between the conducting element (5) made of the second metal alloy and the tip.

6. A method according to claim 3, **characterized in that** the thermocouple is completed by fixing a polarity conductor (8) to said end (10) of the conducting element made of the second metal alloy which protrudes into the tube length, and a ground conductor (11) which is directly welded outside the conductor body (2), at a second end (20) of the body opposite to said first end (21), directly onto said side wall (13) of the tube length.

7. A thermocouple (1) of the type comprising: an electrically conducting body (2) fixable in use to a burner of a cooking range; a hot junction (3) consisting of a tip (4) made of a first conducting metal alloy, integrally carried by the body and by a conducting element (5) made of a second metal alloy, accommodated within the tip, welded to a first end (6) thereof; an insulating element (7) interposed between the tip and the conducting element made of the second metal alloy; a polarity wire (8) connected to the conducting element made of the second metal alloy; and a ground wire (11) directly connected to the conducting body; **characterized in that** said conducting body (2) is a tube length (12) made of a metal sheet which has been plastically deformed and sheared, and which is delimited by a side wall (13) being less than 1 mm thick on which at least one annular axial abutment (15) has been obtained and, at a predetermined axial distance from the axial abutment, at least one annular groove (16) has been obtained by plastically deforming the side wall (13) towards the interior of the tube length; said tube length (12) having been obtained so that the same defines a cup-shaped dead bush (30) delimited by said side wall (13) with said axial abutment (15) and by a flat bottom wall (31) provided with a through hole (32) adapted to make a through seat (22) for accommodating the tip (4)

8. A thermocouple according to claim 7, **characterized in that** the side wall (13) of the tube length consists of an axial sequence of revolution surface segments (18, 19) of different outer diameter, two of said surface segments (18, 19) immediately adjacent to each other defining said annular axial abutment (15).

9. A thermocouple according to claim 7 or 8, **characterized in that** said side wall (13) of the tube length defining said conducting body (2) is from 0.5 to 0.8 mm thick.

10. A thermocouple according to one of claims 7 to 9, **characterized in that** it further comprises an elastically deformable clip (25) for fastening the body to a burner of a cooking range, adapted to be snappingly coupled to said at least one annular groove (16).

## Patentansprüche

1. Verfahren zur Herstellung eines Thermoelements
(1) der Art, die einen elektrisch leitfähigen Körper
(2) umfasst, der im Gebrauch an einem Brenner eines Kochbereichs fixierbar ist, und eine Heißlötstelle (3), bestehend aus einer Spitze, die aus einer ersten leitfähigen Metalllegierung gefertigt ist und an einem Stück vom Körper getragen wird, und aus einem leitfähigen Element, das aus einer zweiten Metalllegierung gefertigt ist und in der Spitze aufgenommen ist, und an einem Ende davon angeschweißt ist, das die folgenden Schritte umfasst:
- Bilden einer Rohrlänge (12), die von einer Seitenwand (13) begrenzt wird, die eine Dicke von weniger als 1 mm aufweist, ausgehend von einem flachen Blech, durch plastische Verformung und Abscherung des Blechs;
- wiederum durch plastische Verformung der Seitenwand (13) Bilden wenigstens eines ringförmigen axialen Widerlagers (15) und in einem vorbestimmten axialen Abstand von dem axialen Widerlager wenigstens einer ringförmigen Nut (16), die durch plastische Verformung der Seitenwand (13) zum Innenraum der Rohrlänge hin erhalten wird, um den Körper (2) zu bilden;
- Bilden der Heißlötstelle (3) und anschließend axiales Einführen der Heißlötstelle in den Körper, damit die Spitze (4) aus einem ersten Ende des Körpers (2) austritt; und
- Anschweißen der Spitze (4) an der Seitenwand (13) des Körpers; **dadurch gekennzeichnet, dass** die Rohrlänge (12) dadurch erhalten wird, dass das Blech zuerst bearbeitet wird, um eine becherförmige Leerbuchse (30) zu bilden, die von der Seitenwand (13) und von einer flachen Bodenwand (31) begrenzt wird; und anschließendes Abscheren eines Durchgangslochs (32) durch die flache Bodenwand (31), um einen durchgehenden Sitz (22) zur Aufnahme der Spitze (4) zu erhalten; wobei das axiale Widerlager (15) an der Seitenwand (13) während des Schritts der Bearbeitung des Blechs gebildet wird.

2. Verfahren nach Anspruch 1, **dadurch gekennzeichnet, dass** die Rohrlänge (12) durch Ziehen des Blechs, wenn dieses noch flach ist, erhalten wird, um die Leerbuchse (30) zu bilden.

3. Verfahren nach Anspruch 1, **dadurch gekennzeichnet, dass** die Rohrlänge (12) durch Abscheren und Biegen des flachen Metallblechs erhalten wird, wobei die Kontinuität der Seitenwand (13) von einer Längsverbindung unterbrochen wird, die von gegenüberliegenden Längskanten des abgescherten und gebogenen Blechs definiert wird.

4. Verfahren nach einem der vorhergehenden Ansprüche, **dadurch gekennzeichnet, dass** die Seitenwand (13) der Rohrlänge als axiale Reihenfolge von Rotationsflächensegmenten (18, 19) mit unterschiedlichem Außendurchmesser geformt wird.

5. Verfahren nach einem der vorhergehenden Ansprüche, **dadurch gekennzeichnet, dass** die Heißlötverbindung (3) so gefertigt wird, dass bei der Einführung in den leitfähigen Körper (2), der von der Rohrlänge definiert wird, ein Ende (10) des leitfähigen Elements (5), das aus der zweiten Metalllegierung gefertigt ist, von der Seite, die der Spitze (4) gegenüberliegt, in die Rohrlänge ragt; wobei eine isolierende Hülle (7) aus Glasfaser dann zwischen dem leitfähigen Element (5), das aus der zweiten Metalllegierung besteht, und der Spitze eingeführt wird.

6. Verfahren nach Anspruch 3, **dadurch gekennzeichnet, dass** das Thermoelement durch Befestigung eines Polaritätsleiters (8) am Ende (10) des leitfähigen Elements, das aus der zweiten Metalllegierung besteht, das in die Rohrlänge ragt, und eines Masseleiters (11), der direkt auf der Außenseite des Leiterkörpers (2) angeschweißt ist, an einem zweiten Ende (20) des Körpers gegenüber dem ersten Ende (21), direkt auf der Seitenwand (13) der Rohrlänge fertiggestellt wird.

7. Thermoelement (1) der Art, die das Folgende umfasst: einen elektrisch leitfähigen Körper (2), der im Gebrauch an einem Brenner eines Kochbereichs fixierbar ist; eine Heißlötstelle (3), bestehend aus einer Spitze (4), die aus einer ersten leitfähigen Metalllegierung gefertigt ist und an einem Stück vom Körper getragen wird, und aus einem leitfähigen Element (5), das aus einer zweiten Metalllegierung gefertigt ist und in der Spitze aufgenommen ist, und an einem ersten Ende (6) davon angeschweißt ist; ein isolierendes Element (7), das zwischen der Spitze und dem leitfähigen Element aus der zweiten Metalllegierung angeordnet ist; einen Polaritätsdraht (8), der mit dem leitfähigen Element aus der zweiten Metalllegierung verbunden ist; und einen Erdungsdraht (11), der direkt mit dem leitfähigen Körper verbunden ist; **dadurch gekennzeichnet, dass** der leitfähige Körper (2) eine Rohrlänge (12) aus Blech ist, die plastisch verformt und abgeschert wurde, und die von einer Seitenwand (13) begrenzt wird, die eine Dicke von weniger als 1 mm aufweist, auf der wenigstens ein ringförmiges axiales Widerlager (15) erhalten wurde, und in einem vorbestimmten axialen Abstand von dem axialen Widerlager, wenigstens eine ringförmige Nut (16) durch plastische Verformung der Seitenwand (13) zum Innenraum der Rohrlänge hin erhalten wurde; wobei die Rohrlänge (12) so erhalten wurde, dass sie eine becherförmige Leerbuchse (30) bildet, die von der Seitenwand (13) mit dem axialen Widerlager (15) und von einer flachen Bodenwand (31) begrenzt wird, die mit einem Durchgangsloch (32) versehen ist, das dazu ausgelegt ist, einen durchgehenden Sitz (22) zur Aufnahme der Spitze (4) zu bilden.

8. Thermoelement nach Anspruch 7, **dadurch gekennzeichnet, dass** die Seitenwand (13) der Rohrlänge aus einer axialen Reihenfolge von Rotationsflächensegmenten (18, 19) mit unterschiedlichem Außendurchmesser besteht, wobei zwei der Oberflächensegmente (18, 19), die unmittelbar nebeneinander liegen, das ringförmige axiale Widerlager (15) bilden.

9. Thermoelement nach Anspruch 7 oder 8, **dadurch gekennzeichnet, dass** die Seitenwand (13) der Rohrlänge, die den leitfähigen Körper (2) definiert, 0,5 bis 0,8 mm dick ist.

10. Thermoelement nach einem der Ansprüche 7 bis 9, **dadurch gekennzeichnet, dass** es ferner eine elastisch verformbare Klammer (25) zur Befestigung des Körpers an einem Brenner eines Kochbereichs umfasst, die dazu ausgelegt ist, einschnappend mit der wenigstens einen ringförmigen Nut (16) verbunden zu werden.

## Revendications

1. Procédé de fabrication d'un thermocouple (1) du type comportant un corps électriquement conducteur (2) pouvant être fixé en cours d'utilisation à un brûleur de cuisinière et une jonction chaude (3) composée d'une pointe constituée d'un premier alliage métallique conducteur, portée de manière intégrée par le corps, et d'un élément conducteur constitué d'un deuxième alliage métallique, logé à l'intérieur de la pointe, soudé à une de ses extrémités, comportant les étapes consistant à :
- former une longueur (12) de tube délimitée par une paroi latérale (13) de moins de 1 mm d'épaisseur en partant d'une tôle métallique plate en déformant plastiquement et en cisaillant ladite tôle métallique ;
- à nouveau en déformant plastiquement ladite paroi latérale (13), former au moins une butée axiale annulaire (15) et, à une distance axiale prédéterminée de la butée axiale, au moins une gorge annulaire (16) obtenue en déformant plastiquement la paroi latérale (13) vers l'intérieur de la longueur de tube de façon à réaliser ledit corps (2) ;
- former ladite jonction chaude (3) puis l'insérer axialement dans le corps de façon à faire sortir la pointe (4) par une première extrémité du corps (2) ; et souder la pointe (4) à la paroi latérale (13) du corps ; **caractérisé en ce que** ladite longueur (12) de tube est obtenue en travaillant d'abord ladite tôle métallique de façon à former un fourreau (30) d'arrêt en forme de gobelet délimité par ladite paroi latérale (13) et par une paroi (31) de fond plat ; puis en pratiquant par cisaillement un trou débouchant (32) à travers la paroi (31) de fond plat, de façon à obtenir un siège perforé (22) servant à loger la pointe (4) ; ladite butée axiale (15) étant réalisée sur la paroi latérale (13) pendant ladite étape consistant à travailler la tôle métallique.

2. Procédé selon la revendication 1, **caractérisé en ce que** ladite longueur (12) de tube est obtenue en emboutissant ladite tôle métallique lorsqu'elle est encore plate, de façon à former ledit fourreau (30) d'arrêt.

3. Procédé selon la revendication 1, **caractérisé en ce que** ladite longueur (12) de tube est obtenue en cisaillant et en cintrant ladite tôle métallique plate, la continuité de ladite paroi latérale (13) étant interrompue par une jonction longitudinale définie par des bords longitudinaux opposés de la tôle cisaillée et cintrée.

4. Procédé selon l'une des revendications précédentes, **caractérisé en ce que** ladite paroi latérale (13) de la longueur de tube est formée comme une succession axiale de segments (18, 19) de surface de révolution de diamètre extérieur différent.

5. Procédé selon l'une des revendications précédentes, **caractérisé en ce que** la jonction chaude (3) est réalisée de telle façon que, suite à son insertion dans le corps conducteur (2) défini par ladite longueur de tube, une extrémité (10) de l'élément conducteur (5) constitué du deuxième alliage métallique dépasse jusque dans la longueur de tube à partir du côté opposé à la pointe (4) ; une gaine isolante (7) constituée de fibre de verre étant alors insérée entre l'élément conducteur (5) constitué du deuxième alliage métallique et la pointe.

6. Procédé selon la revendication 3, **caractérisé en ce que** le thermocouple est achevé en fixant un conducteur (8) de polarité à ladite extrémité (10) de l'élément conducteur constitué du deuxième alliage métallique qui dépasse jusque dans la longueur de tube, et un conducteur (11) de terre qui est soudé directement à l'extérieur du corps conducteur (2) à une deuxième extrémité (20) du corps opposée à ladite première extrémité (21), directement sur ladite paroi latérale (13) de la longueur de tube.

7. Thermocouple (1) du type comportant : un corps électriquement conducteur (2) pouvant être fixé en cours d'utilisation à un brûleur de cuisinière ; une jonction chaude (3) composée d'une pointe (4) constituée d'un premier alliage métallique conducteur, portée de manière intégrée par le corps et par un élément conducteur (5) constitué d'un deuxième alliage métallique, logé à l'intérieur de la pointe, soudé à une première extrémité (6) de celle-ci ; un élément isolant (7) interposé entre la pointe et l'élément conducteur constitué du deuxième alliage métallique ; un fil (8) de polarité relié à l'élément conducteur constitué du deuxième alliage métallique ; et un fil (11) de terre directement relié au corps conducteur ; **caractérisé en ce que** ledit corps conducteur (2) est une longueur (12) de tube constituée d'une tôle métallique qui a été déformée plastiquement et cisaillée, et qui est délimitée par une paroi latérale (13) de moins de 1 mm d'épaisseur sur laquelle au moins une butée axiale annulaire (15) a été obtenue et, à une distance axiale prédéterminée de la butée axiale, au moins une gorge annulaire (16) a été obtenue en déformant plastiquement la paroi latérale (13) vers l'intérieur de la longueur de tube ; ladite longueur (12) de tube ayant été obtenue de telle façon qu'elle définisse un fourreau (30) d'arrêt en forme de gobelet délimité par ladite paroi latérale (13) avec ladite butée axiale (15) et par une paroi (31) de fond plat munie d'un trou débouchant (32) prévu pour réaliser un siège perforé (22) servant à loger la pointe (4).

8. Thermocouple selon la revendication 7, **caractérisé en ce que** la paroi latérale (13) de la longueur de tube est composée d'une succession axiale de segments (18, 19) de surface de révolution de diamètre extérieur différent, deux desdits segments (18, 19) de surface immédiatement adjacents l'un à l'autre définissant ladite butée axiale annulaire (15).

9. Thermocouple selon la revendication 7 ou 8, **caractérisé en ce que** ladite paroi latérale (13) de la longueur de tube définissant ledit corps conducteur (2) présente une épaisseur de 0,5 à 0,8 mm.

10. Thermocouple selon l'une des revendications 7 à 9, **caractérisé en ce qu'**il comporte en outre une attache (25) élastiquement déformable servant à fixer le corps à un brûleur de cuisinière, prévue pour être couplée par encliquetage à ladite ou auxdites gorges annulaires (16).
